# EUROPÄISCHE PATENTSCHRIFT

(11) **EP 1 116 330 B1**
(45) Veröffentlichungstag und Bekanntmachung des Hinweises auf die Patenterteilung: **24.07.2002**
(21) Anmeldenummer: 99953670.9
(22) Anmeldetag: 01.09.1999
(51) Int. Cl.: H03M 1/06

(54) **DIFFERENTIELLE EINGANGSSCHALTUNG FÜR EIN DIGITALES SIGNALVERARBEITUNGSSYSTEM**
DIFFERENTIAL INPUT CIRCUIT FOR DIGITAL SIGNAL PROCESSING SYSTEM
CIRCUIT DIFFERENTIEL D'ENTREE POUR SYSTEME DE TRAITEMENT NUMERIQUE DES SIGNAUX

(30) Priorität: 04.09.1998 DE 19840443
(43) Veröffentlichungstag der Anmeldung: 18.07.2001
(73) Patentinhaber: Micronas Munich GmbH, 81541 München (DE)
(72) Erfinder: KUTTNER, Franz, A-9524 St. Ulrich (AT)
(74) Vertreter: Bickel, Michael
(86) Internationale Anmeldenummer: DE9902757
(87) Internationale Veröffentlichungsnummer: WO0014883

(56) Entgegenhaltungen:
- EP-A- 0 178 044
- EP-A- 0 539 259
- EP-A- 0 714 169
- PATENT ABSTRACTS OF JAPAN vol. 017, no. 359 (E-1395), 7. Juli 1993 (1993-07-07) -& JP 05 055918 A (FUJITSU LTD;OTHERS: 01), 5. März 1993 (1993-03-05)

## Beschreibung

Die Erfindung betrifft eine differentielle Eingangsschaltung für ein digitales Signalverarbeitungssystem, mit einem analogen Differenzeingang und einem Analog/Digital-Wandler sowie einer Einrichtung zur Einstellung eines Gleichanteils in einem digital gewandelten Eingangssignal.

Digitale Signalverarbeitungssysteme haben eine weite Verbreitung gefunden. Da sie gegenüber analogen Schaltungen zahlreiche technische und wirtschaftliche Vorteile besitzen, ersetzen sie die analogen Schaltungen in zunehmendem Maße auch bei solchen Anwendungen, die bisher typischerweise analog realisiert wurden.

Die Übertragung von Signalen erfolgt allerdings in vielen Fällen auf Grund einer in dem Übertragungsmedium nur begrenzt zur Verfügung stehenden Bandbreite analog, so daß den digitalen Signalverarbeitungssystemen ein Analog/Digital-Wandler (A/D-Wandler) vorgeschaltet sein muß. Zur Verbesserung der Störsicherheit werden dabei häufig Eingangsschaltungen mit einem Differenzeingang verwendet, wobei das Eingangssignal häufig über ein Antialias-Filter dem A/D-Wandler zugeführt wird.

Die Signalübertragung mit den üblichen Modulationsverfahren hat jedoch zur Folge, daß das empfangene Signal keinen Gleichanteil (Signalkomponente bei der Frequenz 0) aufweist. Da ein solcher Gleichanteil bei einigen Signalen, wie zum Beispiel Videosignalen mit Schwarzschulter von Bedeutung ist, muß dieser anhand einer mit dem Signal übertragenen Information gesondert rekonstruiert werden.

Zu diesem Zweck sind (differentielle) Eingangsschaltungen bekannt, bei denen ein Gleichanteil des Signals mit Widerständen und Kondensatoren wiedergewonnen und eingestellt werden kann. Ein Nachteil dieser Schaltungen besteht jedoch darin, dass bei einer Fehlanpassung der Widerstände oder einem Offset in einem nachgeschalteten Antialias-Filter oder dem A/D-Wandler die Gleichkomponente des digital gewandelten Eingangssignals fehlerbehaftet ist ("Klemmfehler"). Dies kann im Falle von Videosignalen zu Farbverfälschungen bzw. bei einem Schwarzweiß-Bild zu Farbstichen führen.

Die EP-A-0539259 beschreibt eine differentielle Eingangsschaltung mit einem Analog-Digital-Wandler, einem Mikroprozessor, der die von dem Analog-Digital-Wandler gewandelten analogen Eingangssignale auswertet und Korrekturen zur Erreichung eines Sollwertes durchführt.

Die EP 0714169 A1 beschreibt eine Eingangsschaltung mit einem Analog-Digital-Wandler und einer Vergleichsschaltung, die das durch den Analog-Digital-Wandler gewandelte digitale Eingangssignal mit einem Sollwert zur Einstellung des Gleichanteils des analogen Eingangssignals vergleicht.

Die JP 05055918A beschreibt eine differentielle Eingangsschaltung mit einem analogen Differenzeingang für einen Operationsverstärker. Dem Operationsverstärker ist ein Analog-Digital-Wandler nachgeschaltet, der das analoge Ausgangssignal des Operationsverstärkers in einen digitalen Wert umwandelt. Der digital umgewandelte Wert wird durch eine Auswerteeinrichtung mit einem Sollwert verglichen. Zur Einstellung des Gleichanteils des analogen Eingangssignals wird der analoge Differenzeingang in Richtung auf den Sollwert auf- bzw. entladen.

Der Erfindung liegt die Aufgabe zugrunde, eine differentielle Eingangsschaltung der eingangs genannten Art zu schaffen, damit der Fehler in der Gleichkomponente eines analog übertragenen und digital gewandelten Eingangssignals weitgehend vermieden werden kann.

Diese Aufgabe wird erfindungsgemäß durch eine differentielle Eingangsschaltung mit den im Patentanspruch 1 angegebenen Merkmalen gelöst.

Ein wesentlicher Vorteil der erfindungsgemäßen Eingangsschaltung besteht darin, dass durch die Auswertung des digital gewandelten Eingangssignals die durch ein Antialias-Filter und den A/D-Wandler und ggf. weitere Komponenten verursachten Fehler kompensiert werden.

Vorteilhafte Weiterbildungen und Ausführungsformen der Erfindung sind in den Unteransprüchen eingegeben.

Weitere Einzelheiten, Merkmale und Vorteile der Erfindung ergeben sich aus der folgenden Beschreibung einer bevorzugten Ausführungsform anhand der Zeichnung. Es zeigen:
Fig.1 ein Prinzipschaltbild zur Verdeutlichung der Funktion der erfindungsgemäßen Eingangsschaltung, und
Fig.2 ein Schaltbild der bevorzugten Ausführungsform.

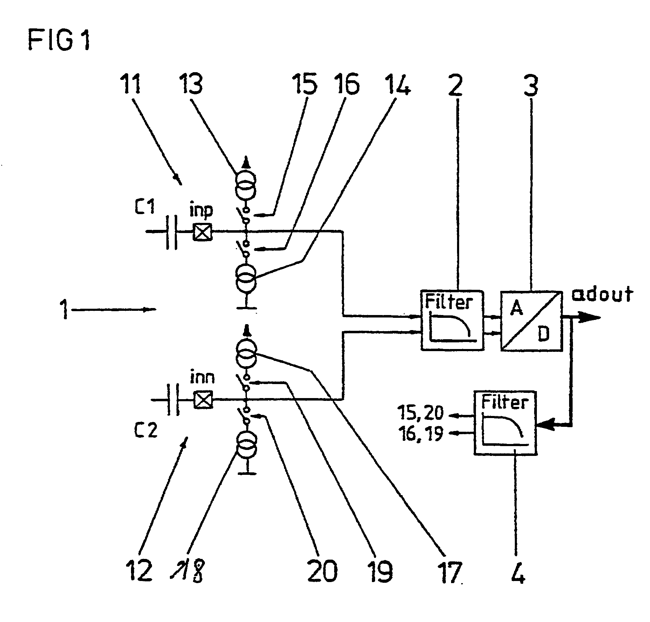

Figur 1 zeigt eine differentielle Eingangsschaltung mit einem Differenzeingang 1, der mit einem an sich bekannten Antialias-Filter 2 verbunden ist. Dessen Ausgänge liegen an einem ebenfalls an sich bekannten A/D-Wandler 3 an. Das von diesem Wandler erzeugte, digital gewandelte Differenz-Eingangssignal (adout)wird einem digitalen Signalverarbeitungssystem und gleichzeitig einer Auswerteeinrichtung 4 zugeführt.

Der Differenzeingang 1 weist einen ersten, nichtinvertierenden Eingangsanschluß 11 (inp) und einen zweiten, invertierenden Eingangsanschluß 12 (inn) auf, die jeweils in üblicher Weise mit einem Kondensator C1, C2 zum Abblocken von Gleichspannungen aus einer vorhergehenden Stufe beschaltet sind.

Eine erste Stromquelle 13 ist zwischen ein positives Bezugspotential und den ersten Eingangsanschluß 11, und eine zweite Stromquelle 14 zwischen den ersten Eingangsanschluß 11 und Masse geschaltet. Weiterhin ist ein erster Schalter 15 zwischen der ersten Stromquelle 13 und dem ersten Eingangsanschluß 11 sowie ein zweiter Schalter 16 zwischen dem ersten Eingangsanschluß 11 und der zweiten Stromquelle 14 vorgesehen.

In entsprechender Weise liegt zwischen dem positiven Bezugspotential und dem zweiten Eingangsanschluß 12 eine dritte Stromquelle 17 und zwischen dem zweiten Eingangsanschluß 12 und Masse eine vierte Stromquelle 18. Beide Stromquellen 17, 18 sind auch hier jeweils über einen dritten bzw. vierten Schalter 19, 20 mit dem zweiten Eingangsanschluß 12 verbindbar.

Die prinzipielle Funktion der Schaltung besteht darin, ein an dem Differenzeingang 1 anliegendes differentielles Eingangssignal nach der Filterung und A/D-Wandlung der Auswerteeinrichtung 4 zuzuführen, in der festgestellt wird, ob sein Gleichanteil über oder unter einem bestimmten Schwellenwert liegt, der auf digitalem Wege, zum Beispiel durch Auswertung einer mit dem Eingangssignal übertragenen Information, ermittelt wird. Ist der Gleichanteil zu gering, so wird der erste Eingangsanschluß 11 über die erste Stromquelle 13 höher geladen, indem die Auswerteeinrichtung 4 durch ein geeignetes Schaltsignal den ersten Schalter 15 schließt. Alternativ dazu kann der Gleichanteil auch durch Entladen des zweiten Eingangsanschlusses 12 über die vierte Stromquelle 18 erhöht werden, indem der vierte Schalter 20 durch ein entsprechendes Schaltsignal von der Auswerteeinrichtung 4 geschlossen wird. Der zweite und der dritte Schalter 16, 19 befindet sich hierbei in geöffnetem Zustand.

Ist im umgekehrten Fall der Gleichanteil zu hoch, so wird der erste Eingangsanschluß 11 über die zweite Stromquelle 14 durch Schließen des zweiten Schalters 16 entladen oder der zweite Eingangsanschluß 12 über die dritte Stromquelle 17 durch Schließen des dritten Schalters 19 geladen. Der erste und der vierte Schalter 15, 20 befindet sich hierbei in geöffneten Zustand. Sämtliche Schalter werden durch die Auswerteeinrichtung 4 geöffnet bzw. geschlossen, indem entsprechende Schaltsignale erzeugt werden.

Die Nachführung des Gleichpegels kann langsam durchgeführt werden. Die Regelung kann dabei durch ein digitales Filter unempfindlich gegen Störungen gemacht werden. Die Regelschleife zieht zwar die Differenz der Analogsignale auf den gewünschten Wert. Bei dieser Anordnung ist jedoch eine Regelung für das Gleichtaktsignal der Analogeingänge noch nicht vorgesehen.

Zur Gleichtaktregelung wird deshalb von der Tatsache Gebrauch gemacht, daß die Regelung des Differenzsignals am ersten (nichtinvertierenden) oder am zweiten (invertierenden) Eingangsanschluß 11 bzw. 12 durchgeführt werden kann. Sofern also die Differenz erhöht werden soll, kann dies durch Schließen des ersten Schalter 15 am ersten Eingangsanschluß 11 oder durch Schließen des vierten Schalter 20 am zweiten Eingangsanschluß 12 erfolgen. In umgekehrter Weise kann die Differenz vermindert werden, wenn der zweite Schalter 16 am ersten Eingangsanschluß 11 oder der dritte Schalter 19 am zweiten Eingangsanschluß 12 geschlossen wird. Die anderen Schalter sind dabei jeweils offen.

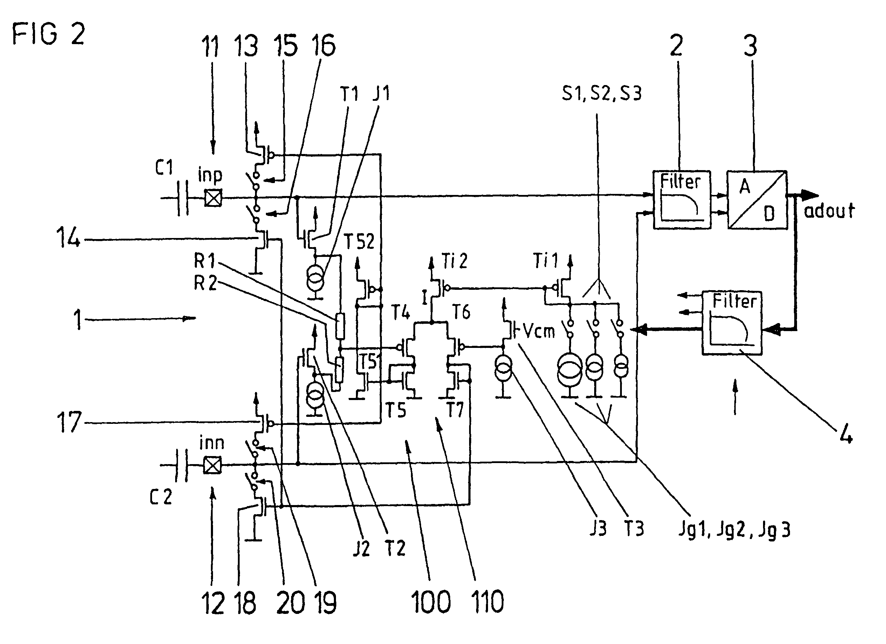

Figur 2 zeigt eine bevorzugte Ausführungsform der erfindungsgemäßen differentiellen Eingangsschaltung mit einer Gleichtaktregelung. Die Stromquellen 13, 14, 17, 18 sind jeweils als steuerbares Halbleiterbauelement (insbesondere als Feldeffekt-Transistor) ausgebildet und werden zur Einstellung der Größe des Stroms über ihren Basisbzw. Gateanschluß angesteuert. Darüberhinaus finden sich die in Figur 1 dargestellten Bauelemente auch in dieser Schaltung wieder und sind jeweils mit gleichen Bezugsziffern bezeichnet. Zusätzlich ist eine Ansteuerschaltung 100 für die Stromquellen vorgesehen, die eine Differenzstufe 110 aufweist.

Dieser Differenzstufe 110 wird einerseits die Gleichtaktspannung der Eingangssignale und andererseits eine gewünschte Soll-Gleichtaktspannung Vcm zugeführt.

Im einzelnen wird die an dem ersten Eingangsanschluß 11 anliegende Spannung über einen ersten, als Sourcefolger geschalteten Feldeffekttransistor T1 mit einer Drain-Stromquelle I1 sowie einen ersten Widerstand R1 abgegriffen, während die an dem zweiten Eingangsanschluß 12 anliegende Spannung über einen zweiten, als Sourcefolger geschalteten Feldeffekttransistor T2 mit einer Drain-Stromquelle I2 sowie einen zweiten Widerstand R2 zugeführt wird. Die jeweils anderen Enden des ersten und zweiten Widerstandes R1, R2 sind mit einer Seite der Differenzstufe 110 verbunden. Die beiden Sourcefolger dienen zur Entkopplung und verhindern, daß die analogen Eingangsspannungen durch die Widerstände R1, R2 beeinflußt werden.

An der anderen Seite der Differenzstufe 110 liegt die gewünschte Gleichtaktspannung Vcm an, die über einen dritten, als Sourcefolger geschalteten Feldeffekttransistor T3 mit Drain-Stromquelle I3 zugeführt wird.

Die beiden Seiten der Differenzstufe 110 sind durch jeweils zwei in Reihe geschaltete Transistoren T4 und T5 bzw. T6 und T7 gebildet, wobei die Gleichtaktspannungen jeweils an den Gateanschlüssen des vierten und sechsten Transistors T4, T6 anliegen. Der fünfte Transistor T5 ist über zwei weitere Transistoren T51, T52 mit den Steueranschlüssen der ersten und dritten Stromquelle 13, 15, und der sechste Transistor T6 mit den Steueranschlüssen der zweiten und vierten Stromquelle 14, 16 verbunden.

Weiterhin sind drei parallel geschaltete Stromquellen Ig1, Ig2, Ig3 mit jeweils einem in Reihe dazu liegenden Stromquellenschalter S1, S2, S3 vorgesehen, die je nach der Höhe des in den Differenzeingang einzuspeisenden Stroms durch die Auswerteeinrichtung 4 geschlossen bzw. geöffnet werden. Die Stromquellen sind zu diesem Zweck über zwei weitere Transistoren Ti1, Ti2 mit dem Verbindungspunkt des vierten und sechsten Transistors T4, T6 verbunden.

Da alle drei Sourcefolger (Transistoren T1, T2, T3) identisch sind, wird von der Differenzstufe 110 nur die Differenz zwischen der Gleichtaktspannung an den Eingangsanschlüssen und der gewünschte Gleichtaktspannung Vcm ausgewertet. Die Differenzstufe 100 verteilt dabei den an ihrem Fußpunkt eingespeisten Strom in der Weise, daß in Abhängigkeit von der Abweichung der Gleichtaktspannung des Eingangssignals von der gewünschten Gleichtaktspannung bei jedem Nachstellen des Differenzwertes durch Schließen des ersten und vierten oder zweiten und dritten Schalters 15, 20; 16, 19 die Gleichtaktspannung in der richtigen Richtung nachgestellt wird.

Um die Gleichtaktspannung des digital gewandelten Eingangssignals möglichst schnell an die gewünschte Gleichtaktspannung Vcm anzugleichen, wird durch die Auswerteeinrichtung 4 nicht nur ermittelt, in welche Richtung die Gleichtaktspannung zu verändern ist, sondern auch wie groß die Differenz zwischen beiden Spannungen ist. In Abhängigkeit von der Größe dieser Differenz wird der Klemmstrom über einen Steuerausgang Si der Auswerteeinrichtung 4 durch entsprechendes Schließen der Stromquellenschalter S1, S2, S3 bei großen Abweichungen möglichst groß gemacht. Dies bewirkt insbesondere beim Einschalten ein schnelleres Einschwingen auf den gewünschten Wert.

Die Schaltung kann sowohl für eine kontinuierliche Klemmung (der Regelvorgang ist ständig aktiv), als auch für eine getastete Klemmung, wie zum Beispiel bei Videosignalen, bei denen der Gleichanteil nur zu bestimmten Zeiten als Informationssignal vorhanden ist, verwendet werden. Zu diesem Zweck kann der Auswerteeinrichtung 4 ein Klemm-Schaltsignal Sk zugeführt werden, mit dem diese nur zu den Klemmzeitpunkten aktiv geschaltet wird.

## Patentansprüche

1. Differentielle Eingangsschaltung für ein digitales Signalverarbeitungssystem mit:
einem analogen Differenzeingang (1) zum Anlegen eines analogen Eingangssignals;
einem Analog/Digital-Wandler (3) zur Umwandlung des an dem analogen Differenzeingangs (1) anliegenden analogen Eingangssignals in ein digital gewandeltes Eingangssignal;
einer mit dem Ausgang des Analog/Digital-Wandlers (3) verbundenen Auswerteeinheit (4) zum Vergleichen eines Signal-Gleichanteils des digital gewandelten Eingangssignals mit einem Gleichanteil-Sollwert,
**dadurch gekennzeichnet,**
**dass** mindestens eine Stromquelle(13, 14, 17, 18) vorgesehen ist, die mittels eines zugehörigen Schalters (15, 16, 19, 20) an den analogen Differenzeingang (1) zum Laden oder Entladen des analogen Differenzeinganges (1) derart schaltbar ist, dass eine Gleich- und Gegentaktspannung des digital gewandelten analogen Eingangssignals auf eine Sollspannung geregelt wird.

2. Eingangschaltung nach Anspruch 1,
**dadurch gekennzeichnet,**
**dass** die Stromquellen (13, 14, 17, 18) durch steuerbare Halbleiterbauelemente gebildet sind, die durch eine Ansteuerschaltung (100) zum Vergleichen einer Sollwert-Gleichtaktspannung mit einer Gleichtaktspannung des analogen Eingangssignals derart ansteuerbar sind, dass in Abhängigkeit von der Differenz zwischen der Gleichtaktspannung und der Sollwert-Gleichtaktspannung bei jeder Betätigung eines der Schalter (15, 16, 19, 20) die Gleichtaktspannung nachgestellt wird.

3. Eingangsschaltung nach Anspruch 1 oder 2,
**dadurch gekennzeichnet,**
**dass** der analoge Differenzeingang (1) einen nichtinvertierenden Eingangsanschluss (11) und einen invertierenden Eingangsanschluss (12) aufweist, wobei dem nichtinvertierenden Eingangsanschluss (11) eine erste und eine zweite Stromquelle (13, 14) und dem invertierenden Eingangsanschluss (12) eine dritte und vierte Stromquelle (17, 18) zugeordnet sind, die jeweils zum Laden oder Entladen des Differenzeinganges (1) durch Betätigung des zugehörigen Schalters (15, 16, 19, 20) durch die Auswerteeinrichtung (4) an den Differenzeingang (1) schaltbar sind.

4. Eingangsschaltung nach Anspruch 3,
**dadurch gekennzeichnet,**
**dass** die erste Stromquelle (13) zwischen einem positiven Bezugspotential und dem nichtinvertierenden Eingangsanschluss (11), die zweite Stromquelle (14) zwischen einem Massepotential und dem nichtinvertierenden Eingangsanschluss (11), die dritte Stromquelle (17) zwischen einem positiven Bezugspotential und dem invertierenden Eingangsanschluss (12) und die vierte Stromquelle (18) zwischen dem Massepotential und dem invertierenden Eingangsanschluss (12) geschaltet ist.

5. Eingangsschaltung nach einem der vorhergehenden Ansprüche 1-4,
**dadurch gekennzeichnet,**
**dass** zwischen dem analogen Differenzeingang (1) und dem Analog/Digital-Wandler (3) ein Antialias-Filter geschaltet ist.

6. Eingangsschaltung nach einem der vorhergehenden Ansprüche 1-5,
**dadurch gekennzeichnet,**
**dass** die Auswerteeinrichtung (4) mindestens ein Tiefpassfilter aufweist.

## Claims

1. Differential input circuit for a digital signal processing system with:
an analogue differential input (1) for the application of an analogue input signal;
an analogue/digital converter (3) for converting the analogue input signal present at the analogue differential input (1) into a digitally converted input signal;
an evaluation unit (4) connected to the output of the analogue/digital converter (3) for comparing a DC signal component of the digitally converted input signal with the reference value of a DC component,
**characterised in that** at least one current source (13, 14, 17, 18) is provided that can be switched onto the analogue differential input (1) by means of an associated switch (15, 16, 19, 20) for charging or discharging the analogue differential input (1) in such a way that a common-mode and series-mode voltage of the digitally converted analogue input signal is controlled to a reference voltage.

2. Input circuit according to Claim 1, **characterised in that** the current sources (13, 14, 17, 18) are formed by controllable semiconductor devices, which can be controlled by a control circuit (100) for the comparison of a reference common-mode voltage with a common-mode voltage of the analogue input signal in such a way that, depending upon the difference between the common-mode voltage and the reference common-mode voltage, the common-mode voltage is readjusted on each operation of one of the switches (15, 16, 19, 20).

3. Input circuit according to Claim 1 or 2, **characterised in that** the analogue differential input (1) has a non-inverting input connection (11) and an inverting input connection (12), a first and a second current source (13, 14) being assigned to the non-inverting input connection (11) and a third and fourth current source (17, 18) being assigned to the inverting input connection (12), which can be switched to the differential input (1) for respectively charging or discharging the differential input (1) by means of the operation of the associated switch (15, 16, 19, 20) by the evaluation unit (4).

4. Input circuit according to Claim 3, **characterised in that** the first current source (13) is connected between a positive reference potential and the non-inverting input connection (11), the second current source (14) is connected between a ground potential and the non-inverting input connection (11), the third current source (17) is connected between a positive reference potential and the inverting input connection (12) and the fourth current source (18) is connected between the ground potential and the inverting input connection (12).

5. Input circuit according to one of the preceding Claims 1 - 4, **characterised in that** an anti-alias filter is connected between the analogue differential input (1) and the analogue/digital converter (3).

6. Input circuit according to one of the preceding Claims 1 - 5, **characterised in that** the evaluation unit (4) has at least one low-pass filter.

## Revendications

1. Circuit d'entrée différentiel pour un système de traitement numérique des signaux, comprenant :
- une entrée de différence, analogique (1) pour appliquer un signal d'entrée analogique,
- un convertisseur analogique/numérique (3) pour convertir le signal d'entrée analogique appliqué à l'entrée de différence analogique (1) en un signal d'entrée transformé en signal numérique,
- une unité d'exploitation (4) reliée à la sortie du convertisseur analogique/numérique (3) pour comparer la composante continue du signal d'entrée converti en signal numérique à une valeur de consigne de partie continue,
**caractérisé en ce qu'**
au moins une source de courant (13, 14, 17, 18) peut être commutée par l'intermédiaire d'un commutateur correspondant (15, 16, 19, 20) à l'entre de différence analogique (1) pour charger ou décharger l'entrée de différence analogique (1) de façon à réguler une tension synchrone et une tension en opposition du signal d'entrée analogique converti en signal numérique par rapport à une tension de consigne.

2. Circuit d'entrée selon la revendication 1,
**caractérisé en ce que**
les sources de courant (13, 14, 17, 18) sont constitués par des composants semi-conducteurs commandés, ces composants sont commandés par un circuit de commande (100) pour comparer une tension synchrone de consigne à une tension synchrone du signal d'entrée analogique de façon qu'en fonction de la différence entre la tension synchrone et la tension de consigne, à chaque actionnement d'un commutateur (15, 16, 19, 20), on règle la tension synchrone.

3. Circuit d'entrée selon la revendication 1 ou 2,
**caractérisé en ce que**
l'entrée de différence, analogique (1) comporte une borne d'entrée (11) non inversée et une borne d'entrée inversée (12) et la borne d'entrée non inversée (11) comporte une première et une seconde sources de courant (13, 14) et l'entrée inversée (12) comporte une troisième et une quatrième sources de courant (17, 18) commutées chaque fois pour charger ou décharger l'entrée de différence (1) par l'actionnement du commutateur correspondant (15, 16, 19, 20) par l'installation d'exploitation (4) à l'entrée de différence (1).

4. Circuit d'entrée selon la revendication 3,
**caractérisé en ce que**
la première source de courant (13) est branchée entre un potentiel de référence positif et la borne d'entrée non inversée (11), la seconde source de courant (14) est branchée entre la masse et la borne d'entrée non inversée (11), la troisième source de courant (17) est branchée entre un potentiel de référence positif et la borne d'entrée inversée (12) et la quatrième source de courant (18) est branchée entre la masse et la borne d'entrée inversée (12).

5. Circuit d'entrée selon l'une quelconque des revendications précédentes 1 à 4,
**caractérisé**
**par** un filtre anti-repliement entre l'entrée de différence analogique (1) et le convertisseur analogique/numérique (3).

6. Circuit d'entrée selon l'une quelconque des revendications précédentes 1 à 6,
**caractérisé en ce que**
l'installation d'exploitation (4) comporte au moins un filtre passe bas.
